Europäisches Patentamt

European Patent Office

Office européen des brevets

(11) Publication number: **0 157 054**
A1

## (12) EUROPEAN PATENT APPLICATION

(21) Application number: 84309061.4

(51) Int. Cl.⁴: **H 02 H 3/33**

(22) Date of filing: 21.12.84

(30) Priority: 23.01.84 GB 8401699

(43) Date of publication of application: 09.10.85
Bulletin 85/41

(84) Designated Contracting States: **AT BE CH DE FR GB IT LI LU NL SE**

(71) Applicant: **DURAPLUG ELECTRICALS LIMITED,**
Westwood Works Margate Road, Broadstairs Kent
CP10 2QL (GB)

(72) Inventor: **Akehurst, Douglas John, 41 Wakefield Way,**
Hythe Kent CT21 6HU (GB)

(74) Representative: **Lerwill, John et al, A.A. Thornton & Co.**
Northumberland House 303-306 High Holborn, London,
WC1V 7LE (GB)

(54) Residual current circuit breaker.

(57) A sensor device for a residual current circuit breaker has a magnetic core (1) on which portions of respective conductors (3, 4) carrying current to and from a load are wound, and a Hall Effect element (2) located in an air gap in the core for producing an output signal dependent upon the resultant flux intensity induced in the core. The circuit breaker includes a signal processor (16) controlling actuation of a tripping solenoid (11) to open contacts (RC1, RC2) to interrupt supply of electric power to a load (10) when the currents flowing in the respective conductors (3, 4) differ by more than a given amount.

TITLE MODIFIED
see (  ...  .

- 1 -

## IMPROVEMENTS IN OR RELATING TO
## RESIDUAL CURRENT CIRCUIT BREAKERS

This invention relates to residual current circuit breakers, otherwise known as earth leakage circuit breakers, and in particular refers to a sensor device suitable for use in such circuit breakers.

Residual current circuit breakers are employed as safety devices and serve to interrupt the supply of electric power to a load, especially hand held electrical appliances, when a predetermined imbalance occurs in the currents flowing in the supply and return conductors connecting the load to the electric supply. Typically the devices are adapted to operate to cut off the power supply in response to an earth leakage current of 10ma, 30ma, 100ma or 300ma. In order to sense an imbalance of this order in the current loading of the line and return conductors a very sensitive detector is required. The residual current circuit breakers presently available on the market have earth leakage current sensing components comprising a toroidal ring of magnetic material which forms an annular core. The line and return conductors are each wound onto the core with a few turns, but in opposite senses so that the magnetic fluxes induced in the core by the currents flowing in the conductors will be directed oppositely and have a self cancelling effect. For sensing the resultant magnetic flux induced in the core a sensing coil is also occur when there is an earth leakage current in the order of only tens of milliamps a very large number of turns are needed. Even then very sensitive and hence complicates signal processing circuitry is necessary so that the circuit breaker will respond to the predetermined earth leakage current. The prior art sensing devices are inconvenient and expensive to manufacuture mainly due to the need to provide many turns of the sensor coil on an annular core.

The present invention seeks to provide a solution to the above disadvantages and in accordance with the invention there is provided a sensor device for sensing a deviation between electric currents flowing in respective conductors comprising a magnetic core member defining a magnetic circuit, portions of the conductors wound upon the core member for electric currents flowing in the conductors to induce in the magnetic circuit oppositely directed magnetic fluxes, and means for detecing magnetic flux in the magnetic circuit and producing an electrical output signal dependent upon the magnetic flux intensity, characterised in that the magnetic circuit defined by the core member is substantially closed but includes an air gap, and the flux detecting means is a Hall Effect element located in the air gap.

With the device of the invention the need for a sensor coil is completely eliminated and manufacture is thereby simplified. Futhermore, a Hall Effect element can be more sensitive than a sensor coil and produce a larger change in output signal so that the signal processing circuitry may be less sensitive and therefore less complicated and less expensive. For example, a known device including 250 turns in the sensor coil produces an output of 30mv peak to peak when the currents are balanced and this signal increases only to 30.4mv in response to an earth leakage current of 30ma. For a device according to the invention the corresponding values are 2mv and 3.5mv, respectively. In other words the signal changes by 75% compared with 1.3% for the known device.

A further advantage of the sensor device proposed corresponding values are 2mv and 3.5mv, respectively. In other words the signal changes by 75% compared with 1.3% for the known device.

A further advantage of the sensor device proposed according to the invention is that it can operate with DC as well as AC whereas the prior art sensors mentioned above are only suitable for AC.

To enhance the sensitivity of the device it is expedient that the Hall Effect element substantially fills the width of the air gap, and also is dimensioned so that substantially all of the magnetic flux traversing the air gap is transmitted through the element.

The invention also resides in a residual current circuit breaker having a sensor device in accordance with the invention.

A more complete understanding of the invention will be had from the following detailed description which is given with reference to the accompanying drawings, in which:

Figure 1 is a perspective view of a sensor device embodying the invention; and

Figure 2 is a circuit diagram showing the sensor device connected in a residual current circuit breaker controlling the connections between a load and an electrical power source.

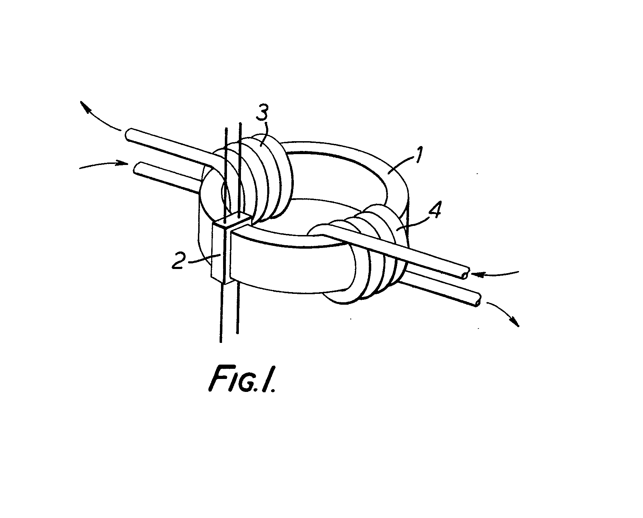

The sensor device illustrated in Figure 1 comprises a magnetic core 1 having the form of a toroid except for a single narrow air gap. Located in the air gap, preferably with a sliding fit or with a small clearance between the opposed pole pieces of the core is a Linear Hall Effect integrated circuit element 2. The element 2 has such a size that substantially all the magnetic flux passing between the pole pieces is transmitted through the element. Two conductor coils 3,4 are wound with an equal number of turns on opposite sides of the core 1, and in use the conductors are connected so that the currents they carry induce oppositely directed magnetic fluxes through the closed magnetic circuit defined by the core 1 and intersected by the Hall element 2. Thus, when the currents flowing in the respective conductors are equal there is no resultant flux in the magnetic circuit and no output signal is produced by the Hall element 2. If the currents carried by the conductor coils differ, however, a magnetic flux is induced in the core 1 and will have an intensity dependent upon the difference between the electric currents, and the Hall element 2 will emit a signal which is proportional to the resultant magnetic flux. To retain the components of the sensor device in correct position it may be embedded in a suitable encapsulation material. and for magnetic screening purposes it may be encased within a layer of ferrous material.

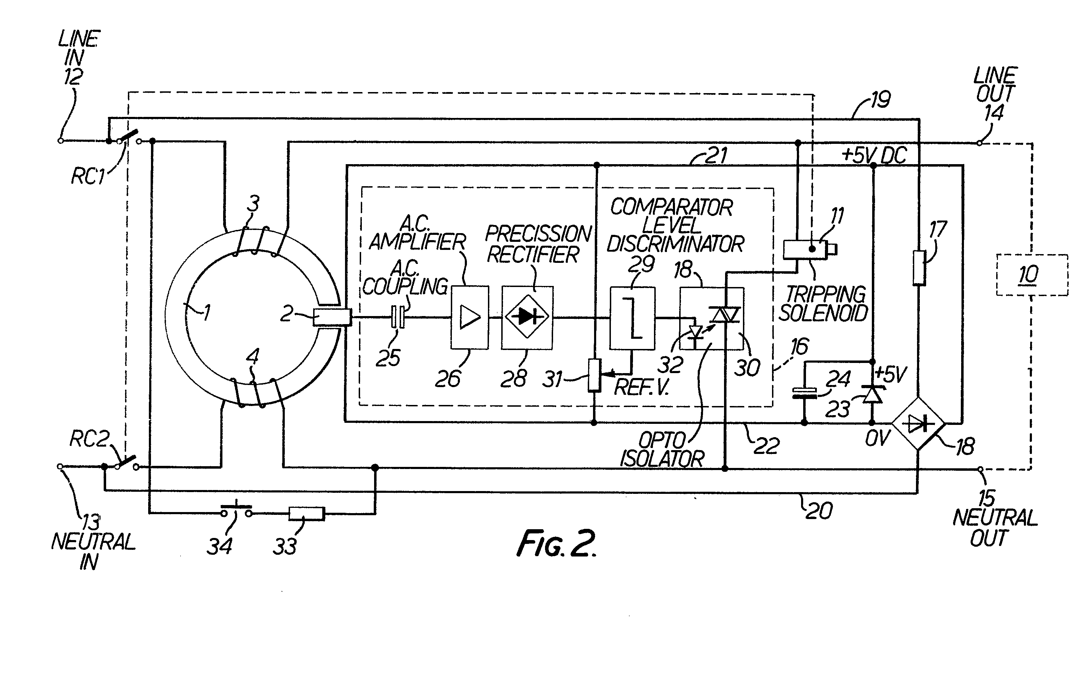

Figure 2 is a diagram showing the sensor device of Figure 1 connected in the electric circuit of a residual current circuit breaker which controls the supply of electric power to a load or applicance 10 (shown in dotted line) from an electric power source, such as the mains AC supply. The circuit breaker includes a switching device constituted by a tripping solenoid 11 and a double pole switch having two sets of contacts RC1 and RC2 through which the conductors 3,4 are respectively connected to terminal connections 12,13 for connection to the Line and Neutral sides of the power supply. The switch is operable manually to open and close the contacts RC1,RC2, and the solenoid is arranged to trip the switch contacts from the closed condition to the open condition when the solenoid is energised. The load 10 is connected between output terminal connections 14,15 at the other ends of the conductors 3,4. The output terminal of the Hall Effect element 2 is connected to the input of a signal processor 16 which is described in detail below. As will become clear, the signal

- 5 -

0157054

process includes a switch component 17 connected in series with the energising coil of the tripping solenoid 11 between the conductors 3,4. In a normal condition of the solenoid 11, the contact sets RC1,RC2 can be closed for the load 10 to be connected to the power supply, and the switch component 17 is operable to actuate the solenoid to open the contact sets RC1,RC2 and thereby disconnect the load from the power supply. Once the solenoid has been actuated to trip open the contact sets, the double pole switch must be reset manually to close the contacts and re-establish the electric current paths between the load and the power source.

To provide a DC power supply for the Hall Effect element and the signal processor 16, a resistor 17 and a rectifier bridge 18 are connected in series across the power input terminals 12,13 through conductor lines 19, 20. The DC output voltage from the bridge 18 is supplied to a pair of DC lines 21,22 and is stablised e.g. at 5 volts, by a zener diode 23 and capacitor 24 connected in parallel between the lines 21,22. The stablised DC voltage is fed to the Hall Effect element 2, and to the signal processor (by connections not shown) through the lines 21,22.

The signal processor includes an AC coupling 25, AC amplifier 26, precision rectifier 28, a comparator 29 and an optical isolator 30 arranged in sequence. The AC coupling 25, conveniently a simple capacitor filters any DC component from the signal emitted by the Hall Effect element 2 before transmitting the signal to the input side of the AC amplifier 26. The amplified signal from the output amplifier 26 is supplied to the input of the precision rectifier 28 which converts it into a DC voltage signal. Thus, the signal emitted from the output of the rectifier is proportional to the AC signal from the Hall element 2, and hence to the flux in the magnetic core 1 and thereby to the difference in the electric currents flowing in the supply and return conductors 3,4. The comparator 29 compares

0157054

- 6 -

the output signal from the rectifier with a reference voltage V conveniently obtained by means of a voltage divider connected across the DC lines 21,22. As shown the voltage divider takes the form of a potentiometer 31 having its wiper contact connected to the comparator, but it could instead be provided by a pair or resistors. The reference voltage is set at such a level, e.g. about 3 volts, that it is normally greater than the signal from the rectifier 27, but the latter signal exceeds the reference voltage when a predetermined imbalance occurs between the currents in the conductors 3,4. The comparator compares the two input signals fed to it and emits an output only when the signal from rectifier 27 is greater than the reference voltage V. The output signal generated by the comparator operates the switching device 17 to trip the solenoid 11 and hence interrupt the electrical connections between the load 10 and the mains power supply. In the illustrated embodiment, the comparator output is coupled to the switching device 17 through an optical isolator. Thus, the comparator output signal is supplied to a light emitting diode 32, and the switching device 17 takes the form of a light activated triac which responds to the light radiated from the diode 32. The optical isolator has the advantage of separating the electronic circuitry of the signal processor from the mains supply, thereby protecting the sensitive components of the signal processor against serious damage should a fault occur in the circuitry of the residual current circuit breaker.

In theory, when the currents flowing in the two conductors 3,4 are equal, there should be no resultant flux induced in the magnetic circuit of the core 1 so that a zero signal is emitted by the Hall element 2. In reality, this theoretically ideal situation is not practically possible and a small background signal will always be emitted by the Hall element. However, this background signal results in a signal from the rectifier stage of the signal processor which is less than the reference voltage V so the switching triac is not triggered and the solenoid is not actuated. As mentioned above, when the currents in conductors 3,4 differ by a predetermined amount, e.g. 10ma, the signal from the Hall element increase to such a level that the voltage of the signal from the rectifier exceeds the reference voltage V resulting in the solenoid 11 being energised to trip open the contacts RC1, RC2 and interrupt the supply of electric power to the load 10. When the cause of the current imbalance has been corrected, the double pole switch can be operated manually to reclose the contacts RC1, RC2 to allow normal operation to be continued.

The AC coupling 25 included at the input of the signal processor acts as a safety device by making the circuit breaker impossible to over-ride by positioning a permanent magnet in the vicinity of the sensor.

The sensor may be provided with magnetic screening to make it insensitive to external magnetic fields, e.g. to avoid spurious operation under the influence of such fields. For this purpose the sensor could be potted within a box of ferrous metal or other suitable ferrous material, or alternatively a coating of ferrous material could be sprayed or otherwise applied to the encapsulated sensor.

In order to enable the circuit breaker to be tested an auxiliary load 33 may be connected in series with a push button switch 34 between the conductors 3,4 to by-pass the coiled portion of one conductor 3. Upon pressing the button to close the switch 34 different current levels will be established in the coiled portions of conductors 3 and 4 and, provided the circuit breaker is functioning correctly, the solenoid 11 will be energised to open the contacts RC1, RC2. After releasing the button to reclose the switch 34 the double pole switch can be operated manually to reclose the contacts RC1, RC2 and thus complete the test procedure.

0157054

- 8 -

CLAIMS:

1.    A sensor device for sensing a deviation between electric currents flowing in respective conductors (3,4), comprising a magnetic core member (1) defining a magnetic circuit, portions of the conductors wound upon the core member for electric currents flowing in the conductors to induce in the magnetic circuit oppositely directed magnetic fluxes, and means for detecting magnetic flux in the magnetic circuit and producing an electrical output signal dependent upon the magnetic flux intensity, characterised in that the magnetic circuit defined by the core member is substantially closed but includes an air gap, and the flux detecting means is a Hall Effect element (2) lcoated in the air gap.

2.    A sensor device according to claim 1, wherein the Hall Effect element (2) substantially fills the width of the air gap between the opposed pole  pieces of the core member (10.

3.    A sensor device according to claim 1 or 2, wherein the Hall Effect element (2) is of such a size that substantially all of the magnetic flux passing between the pole pieces at either side of the air gap is transmitted through said element (2).

4.    A sensor device according to claim 1,2 or 3 wherein the core member is a toroidal ring with a single air gap.

5.    A residual current circuit breaker comprising a sensor device as defined in any one of claims 1 to 4, switch means (RC1,RC2) for controlling the electrical connection of a load (10) to an electrical power supply through the conductors (3,4) of the sensor device, and control means responsive to the output signal from the Hall Effect element (2) of the sensor device for actuating said switch means to interrupt said electrical connection when the electric currents flowing in said conductors (3,4) differ by a predetermined amount.

6. A residual current circuit breaker according to claim 5, wherein the control means includes a tripping solenoid (11), and a signal processor (16) connected to the Hall Effect element (2) and including a switch device (17) connected in series with the energising coil of the solenoid (11) between the conductors (3,4).

7. A residual current circuit breaker according to claim 6, wherein the signal processor (16) comprises means (26,28) for producing a voltage signal proportional to the output signal from the Hall Effect element (2), and means (29) for comparing said voltage signal with a constant reference signal and for emitting an output signal to operate the switch device (17) when said voltage signal exceeds said constant signal.

8. A residual current circuit breaker according to claim 7, wherein the switch device (17) is optically isolated from said signal comparing means.

9. A residual current circuit breaker according to claim 7 or 8, wherein means (17-22) are provided for producing a stabilised DC power supply for the Hall Effect element and the signal processor, and said reference voltage is derived from a voltage divider connected across the DC supply.

10. A residual current circuit breaker according to any one of claims 6 to 9, wherein the signal processor includes an AC coupling (25) for removing any DC component in the output signal from the Hall Effect element (2).

Fig.1.

**FIG. 2.**

## DOCUMENTS CONSIDERED TO BE RELEVANT

| Category | Citation of document with indication where appropriate, of relevant passages | Relevant to claim | CLASSIFICATION OF THE APPLICATION (Int. Cl.4) |
|---|---|---|---|
| X | DE-A-2 102 401 (HARVEY HUBBELL INC.) * Claims 1-4; page 4, line 7 - page 6, line 28; figures 1,2,5 * | 1-7,9 | H 02 H 3/33 |
| Y | | 8,10 | |
| Y | DE-C-1 025 512 (SIEMENS-SCHUCKERTWERKE) * Figure * | 8 | |
| Y | NEW ELECTRONICS, vol. 15, no. 6, March 1982, Southend, GB; B. DANCE "Hall effect devices", pages 82-84 * Page 84; figure 5 * | 10 | |
| A | DE-A-2 819 204 (FELTEN & GUILLEAUME CARLSWERK) * Figure * | 1 | TECHNICAL FIELDS SEARCHED (Int. Cl.4) G 01 R 33/06 H 02 H 3/33 |

The present search report has been drawn up for all claims

| Place of search BERLIN | Date of completion of the search 15-04-1985 | Examiner LEMMERICH J |
|---|---|---|